# EUROPEAN PATENT APPLICATION

(11) **EP 4 601 428 A1**
(43) Date of publication of application: **13.08.2025**
(21) Application number: 24305206.5
(22) Date of filing: 07.02.2024
(51) Int. Cl.: H05K 7/20

(54) **TEMPERATURE CONTROL OF LIQUID-COOLED RACK-MOUNTED ASSEMBLIES**

(71) Applicant: OVH, 59100 Roubaix (FR)
(72) Inventor: VAHIDI FERDOUSI, Mahdi, 59800 Lille (FR); CHEHADE, Ali, 59283 Moncheaux (FR); HNAYNO, Mohamad, 59100 Roubaix (FR)
(74) Representative: BCF Global

(57) **Abstract**

A liquid cooling method and system for a rack-mounted assembly to control cooling liquid temperature are disclosed. The system includes a cooling circuit circulating a cooling liquid to a rack-mounted assembly and a heated liquid from the rack-mounted assembly, a dry cooling module supplying the cooling liquid and receiving the heated liquid for recooling. A controller is communicatively coupled to an input liquid temperature sensor, an output liquid temperature sensor, and a valve. The controller determines an input cooling liquid temperature value, an output heated liquid temperature value, calculates a differential temperature value, and in response to the calculated differential temperature value being below a target differential temperature value, redirects at least a portion of a flow of the heated liquid egressing from an outlet of the rack-mounted assembly to an inlet of the rack-mounted assembly.

## Description

### FIELD OF TECHNOLOGY

The present technology generally relates to the field of datacenter cooling measures and, in particular, to temperature control of liquid-cooled rack-mounted assemblies in datacenters.

### BACKGROUND

Datacenters as well as many other computer processing facilities house multitudes of rack-mounted assemblies and heat-generating electronic data processing elements within those assemblies. In operation, the heat-generating electronic data processing elements generate substantial amounts of heat that must be dissipated in order to avoid electronic component failures and to ensure continued efficient processing operations.

To this end, various liquid cooling solutions have been implemented to facilitate the dissipation of heat generated by the rack-mounted assemblies. One such solution employs liquid block cooling techniques for directly cooling one or more heat-generating electronic data processing elements. This technique utilizes liquid cooling blocks having internal channels that receive cooling liquid from a cooling liquid source, e.g., heat exchangers, dry coolers, municipal water supplies, etc., via a cooling circuit to circulate the cooling liquid throughout the assembly. As such, the liquid cooling blocks are positioned to be in direct thermal contact with the heat-generating electronic data processing elements, so that the received cooling liquid absorbs the generated heat and the heated liquid is circulated, via the cooling circuit, back to the cooling liquid source for recooling.

Another liquid cooling solution employs liquid immersive cooling techniques, in which the heat-generating electronic data processing elements are disposed within an immersion case containing cooling dielectric fluid. In this manner, the submerged heat-generating electronic data processing elements radiate heats that are absorbed by the cooling dielectric fluid in which the heated dielectric fluid is circulated, via a cooling circuit, back to the cooling liquid source for recooling.

Relatedly, hybrid liquid cooling solutions have been introduced that employ a combination of both liquid block cooling techniques and liquid immersive cooling techniques as well as various cooling circuits in efforts to maximize the cooling of the heat-generating electronic data processing elements.

With this said, there remains an interest in improving the temperature control of the cooling liquid received by the rack-mounted assemblies and the temperature control of the heated liquid returned back to the cooling liquid source to optimize cooling efficiency.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

In a first broad aspect, the present technology provides a computer-implemented method for controlling temperature of a cooling liquid of a rack-mounted assembly. The method includes determining an input cooling liquid temperature value of the cooling liquid ingressing into the rack-mounted assembly, determining an output heated liquid temperature value of the cooling liquid egressing from the rack-mounted assembly, calculating a differential temperature value based on the input cooling liquid temperature value and the output heated liquid temperature value, and in response to the calculated differential temperature value being below a target differential temperature value, redirecting at least a portion of a flow of the heated liquid egressing from an outlet of the rack-mounted assembly to an inlet of the rack-mounted assembly.

In some implementations, the redirection is performed by adjusting a valve.

In some implementations, the redirection causes the at least a portion of the flow of the heated liquid being directed to the inlet of a second rack-mounted assembly downstream from the first rack-mounted assembly.

In some implementations, the redirection causes the at least a portion of the flow of the heated liquid being directed to the inlet of the same rack-mounted assembly.

In some implementations, the method further includes predicting, using a machine learning model, a power consumption of the rack-mounted assembly, and adjusting the valve based at least in part on the predicted power consumption of the rack-mounted assembly.

In some implementations, at least one rack-mounted assembly includes an air-to-liquid heat exchanger configured to receive the cooling liquid ingressing into the at least one rack-mounted assembly; and a liquid cooling block receiving the cooling liquid from the air-to-liquid heat exchanger, arranged to be in respective thermal contact with a heat-generating electronic data processing element and configured to output the cooling liquid egressing from the rack-mounted assembly. The method further includes determining an intermediary heated liquid temperature value of the cooling liquid egressing from the air-to-liquid heat exchanger and ingressing into liquid cooling block, determining a second differential temperature value based on the input cooling liquid temperature value and the intermediary heated liquid temperature value and causing, in response to the first and second differential temperature values being below a first temperature threshold and a second temperature threshold respectively, a decrease of a flow rate of the cooling liquid in the rack-mounted assembly.

In some implementations, the method further includes causing, in response to the first differential temperature values being above the first temperature threshold and the second differential temperature values being below a third temperature threshold, an increase of the flow rate of the cooling liquid in the rack-mounted assembly.

In some implementations, the method further includes reducing, in response to the first differential temperature values being below the first temperature threshold and the second differential temperature values being above the second temperature threshold, a rotation speed of at least one fan of the air-to-liquid heat exchanger.

In a second broad aspect, the present technology provides a liquid cooling system for a rack-mounted assembly. The system includes a cooling circuit configured to circulate a cooling liquid to the rack-mounted assembly and to circulate a heated liquid from the rack-mounted assembly, a dry cooling module configured to supply the cooling liquid to the rack-mounted assembly and to receive the heated liquid from the rack-mounted assembly for recooling and recirculation by the cooling circuit. The cooling circuit includes a pump to drive a flow of the cooling liquid supplied by the dry cooling module and to drive a flow of the heated liquid received by the dry cooling module, an input liquid temperature sensor to measure an input cooling liquid temperature value ingressing into the rack-mounted assembly, an output liquid temperature sensor to measure an output heated liquid temperature value egressing from the rack-mounted assembly, and a valve to regulate and direct the flow of the heated liquid egressing from the rack-mounted assembly. The system further includes a controller communicatively coupled to the input liquid temperature sensor, the output liquid temperature sensor, and the valve. The controller is configured to read the input cooling liquid temperature value provided by the input liquid temperature sensor, to read the output heated liquid temperature value provided by the output liquid temperature sensor, to calculate a differential temperature value based on the input cooling liquid temperature value and the output heated liquid temperature value, and in response to the calculated differential temperature value being below a target differential temperature value, redirecting at least a portion of the flow of the heated liquid egressing from an outlet of the rack-mounted assembly to an inlet of the rack-mounted assembly.

In some implementations, the system further includes a heat exchanger arranged to be in respective thermal contact with a heat-generating electronic data processing element of the rack-mounted assembly, the heat exchanger being fluidly-coupled to the cooling circuit to receive the cooling liquid and circulate therethrough, and a liquid cooling block arranged to be in respective thermal contact with the heat-generating electronic data processing element, the liquid cooling block being fluidly-coupled to the cooling circuit to receive the cooling liquid and circulate therethrough.

In some implementations, the redirection is facilitated by adjusting the valve.

In some implementations, the redirection causes the at least a portion of the flow of the heated liquid being directed to a second liquid cooling block of a second rack-mounted assembly downstream from the first rack-mounted assembly.

In some implementations, the redirection causes the at least a portion of the flow of the heated liquid being directed to the liquid cooling block of the same rack-mounted assembly.

In some implementations, the redirection causes the at least a portion of the flow of the heated liquid being directed to the heat exchanger of the same rack-mounted assembly.

In some implementations, the system is further configured to circulate the heated liquid, via an auxiliary cooling circuit. The auxiliary cooling circuit includes a pump to drive the flow of the heated liquid, and a check valve to prevent the backflow of the heated liquid.

In some implementations, the controller is configured to predict, using a machine learning model, a power consumption of the rack-mounted assembly, and to adjust the valve based at least in part on the predicted power consumption of the rack-mounted assembly.

In some implementations, the valve is a 3-way solenoid valve.

In some implementations, the target differential temperature value is set to be between approximately 10 degrees Celsius and approximately 30 degrees Celsius.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects, and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
Figure 1 illustrates a high-level functional block diagram of a liquid cooling arrangement for rack-mounted assemblies, in accordance with an implementation of the present technology;
Figure 2 illustrates a high-level functional block diagram of a liquid cooling arrangement for rack-mounted assemblies, in accordance with another implementation of the present technology;
Figure 3 illustrates a high-level functional block diagram of a liquid cooling arrangement for rack-mounted assemblies, in accordance with yet another implementation of the present technology;
Figure 4 illustrates a flow diagram of a process of controlling temperature of a cooling liquid of a rack-mounted assembly, in accordance with an implementation of the present technology;
Figure 5 illustrates a high-level functional block diagram of a liquid cooling arrangement for rack-mounted assemblies, in accordance with yet another implementation of the present technology;
Figure 6 is high-level functional block diagram of a liquid cooling arrangement for rack-mounted assemblies in accordance with yet another implementation of the present technology;
Figure 7 is flow diagram of a control process of the liquid cooling arrangement of Figure 6 in accordance with an implementation of the present technology; and
Figure 8 is block diagram of a controller in accordance with an embodiment of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the figures including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some implementations of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

With these fundamentals in place, we will now consider some non-limiting examples to illustrate various implementations of aspects of the present disclosure.

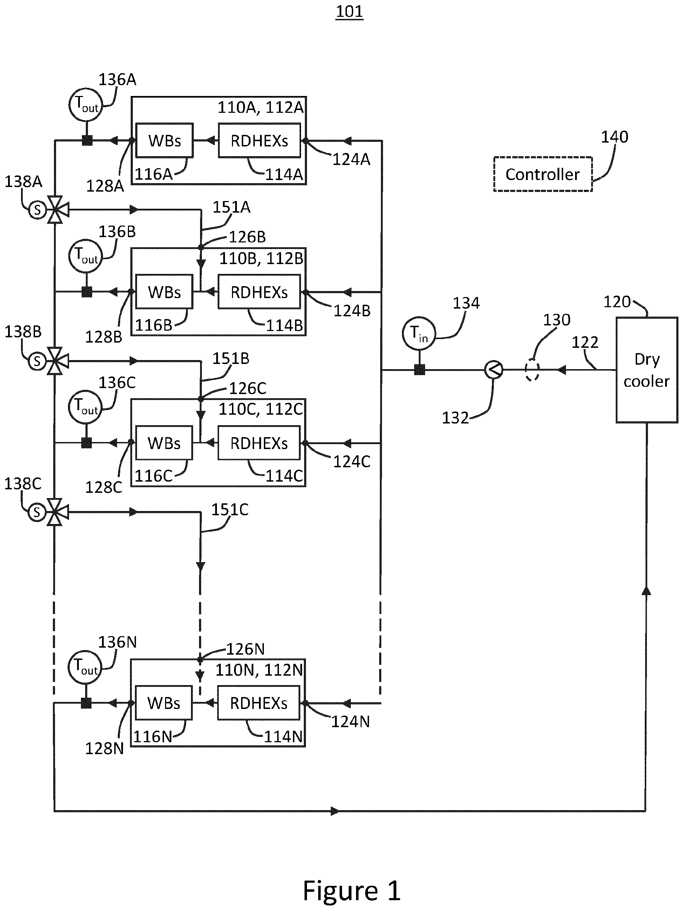

Figure 1 illustrates a general architecture of a liquid cooling system 101 for rack-mounted assemblies 110A-110N, in accordance with an implementation of the present technology. As shown, the liquid cooling system 101 includes a dry cooling module 120, a cooling circuit 130, a plurality of rack-mounted assemblies 110A-110N, and a controller 140.

The dry cooling module 120 is configured to supply cooling liquid 122 to the rack-mounted assemblies 110A-110N and configured to receive heated liquid from the rack-mounted assemblies 110A-110N. The dry cooling module 120 serves to dissipate thermal energy from the heated liquid circulating therethrough to the ambient environment. For example, in a datacenter or a similar computer processing facility, the dry cooling module 120 operates to receive heated liquid from the rack-mounted assemblies 110A-110N (e.g., water circulated through liquid cooling blocks in thermal contact with heat-generating electronic data processing elements) and extracts the thermal energy from the heated liquid by dissipating the thermal energy into the ambient environment via at least one heat exchanger and fan assembly (not shown), thereby recooling the heated liquid. The dry cooling module 120 then operates to supply the recooled liquid back to the rack-mounted assemblies 110A-110N.

The cooling liquid 122 supplied by the dry cooling module 120 is conveyed to the rack-mounted assemblies 110A-110N via the cooling circuit 130. Likewise, the heated liquid from the rack-mounted assemblies 110A-110N is conveyed back to the dry cooling module 120 via the cooling circuit 130. The cooling circuit 130 incorporates a pump 132 to maintain adequate flow rates of the cooling, heated, and subsequently recooled liquids throughout the liquid cooling system 101.

The cooling circuit 130 is configured to fluidly connect the rack-mounted assemblies 110A-110N with the dry cooling module 120. The cooling circuit 130 may be constructed from flexible materials (e.g., rubber, plastic, etc.), rigid materials (e.g., metal, PVC piping, etc.), or any combination of thereof. It will be appreciated that the conveyed cooling liquid 122 may include water, alcohol, or any suitable liquid capable of sustaining adequate cooling temperatures.

As illustrated in Figure 1, the cooling circuit 130 may also includes an input liquid temperature sensor 134, a plurality of output liquid temperature sensors 136A-136N, and a plurality of valves 138A-138N.

The input liquid temperature sensor 134 is configured to measure the input cooling liquid 122 temperature value ingressing into the rack-mounted assemblies 110A-110N, while the output liquid temperature sensors 136A-136N are configured to measure the output heated liquid temperature values egressing from the respective rack-mounted assemblies 110A-110N. Depending on environmental factors and distances traversed, the input cooling liquid 122 temperature value may or may not be the same as the temperature value of the cooling/recooled liquid 122 supplied by the dry cooling unit 120.

The valves 138A-138N, which in some examples of the nonlimiting implementations, may comprise 3-way solenoid valves that are fluidly-coupled to the respective rack-mounted assemblies 110A-110N. Each valve 138A-138N is configured to regulate and direct the flow of the heated liquid egressing from the respective rack-mounted data processing assembly 110A-110N, or a batch of multiple rack-mounted assemblies in the datacenter. In this implementation, each fluid connection going to the batch of multiple rack-mounted assemblies racks may include a 2 way solenoid valve to better direct the fluid to a concerned rack(s) of the batch (not shown).

The rack-mounted assemblies 110A-110N include various heat-generating electronic data processing elements (e.g., Central Processing Units, CPUs) 112A-112N, heat exchangers (e.g., Rear Door Heat Exchangers, RDHEXs) 114A-114N, and liquid cooling blocks (e.g., Water Blocks, WBs) 116A-116N. The heat exchangers 114A-114N and the liquid cooling blocks 116A-116N are arranged to be in respective thermal contact with the heat-generating electronic data processing elements 112A-112N.

As illustrated in Figure 1, the liquid cooling system 101 includes a plurality of rack-mounted assemblies 110A-110N which receive the supplied cooling liquid 122 from the dry cooling module 120. The cooling liquid 122 enters the rack-mounted assemblies 110A-110N via inlets 124A-124N and circulate through the heat exchangers 114A-114N and the liquid cooling blocks 116A-116N. During circulation the cooling liquid 122 absorbs heat generated by the heat-generating electronic data processing elements 112A-112N and the heated liquid exits the rack-mounted assemblies 110A-110N via outlets 128A-128N. The heated liquid then may be conveyed back to the dry cooling module 120 for recooling or may be redirected to another rack-mounted assembly 110A-110N as described further below.

The rack-mounted assemblies 110A-110N may or may not be configured with similar heat-generating electronic data processing elements 112A-112N and the heat-generating electronic data processing elements 112A-112N may not be utilized exactly the same way. As such, each of the rack-mounted assemblies 110A-110N may have different temperature requirements for proper operations. In some implementations, the rack-mounted assemblies 110A-110N are arranged in an ascending power consumption order for efficient operation. More specifically, a first rack-mounted assembly may have a first power consumption that is lower than a second power consumption of a second rack-mounted assembly. The second power consumption of the second rack-mounted assembly may be lower than a third power consumption of a third rack-mounted assembly and so on. The third rack-mounted assembly is disposed downstream from the second rack-mounted assembly and the second rack-mounted assembly is disposed downstream from the first rack-mounted assembly.

It will be appreciated, that while the rack-mounted assemblies 110A-110N are shown to be arranged in a parallel configuration, it is not meant to be limiting, as the rack-mounted assemblies 110A-110N may also be arranged in a serial or combined parallel and serial configuration without departing from the concepts of the instant disclosure.

As mentioned above, the heated liquid egressing out of each of the rack-mounted assemblies 110A-110N is conveyed to the corresponding valve 138A-138N. The temperature value of the cooling liquid 122 ingressing into the rack-mounted assemblies 110A-110N and the temperature value of the heated liquid egressing out of each rack-mounted assembly 110A-110N are measured by the input liquid temperature sensor 134 and the output liquid temperature sensors 136A-136N respectively.

In some implementations, the controller 140 is communicatively coupled to the input liquid temperature sensor 134, to each of the individual output liquid temperature sensors 136A-136N of the respective rack-mounted assemblies 110A-110N, and to each of the individual valves 138A-138N of the respective rack-mounted assemblies 110A-110N.

Based on the measured input cooling liquid 122 temperature value and the output heated liquid temperature value of each of the rack-mounted assemblies 110A-110N, the valves 138A-138N are controlled to regulate and direct the flow of the heated liquid egressing from each of the rack-mounted assemblies 110A-110N to balance and maintain an optimal differential temperature value between the supplied cooling liquid 122 and the returned heated liquid of the liquid cooling system 101. Maintaining this optimal differential temperature value results in improved liquid cooling system 101 efficiency. In other words, the present technology may provide increased cooling capacity with a same amount of cooling liquid 122.

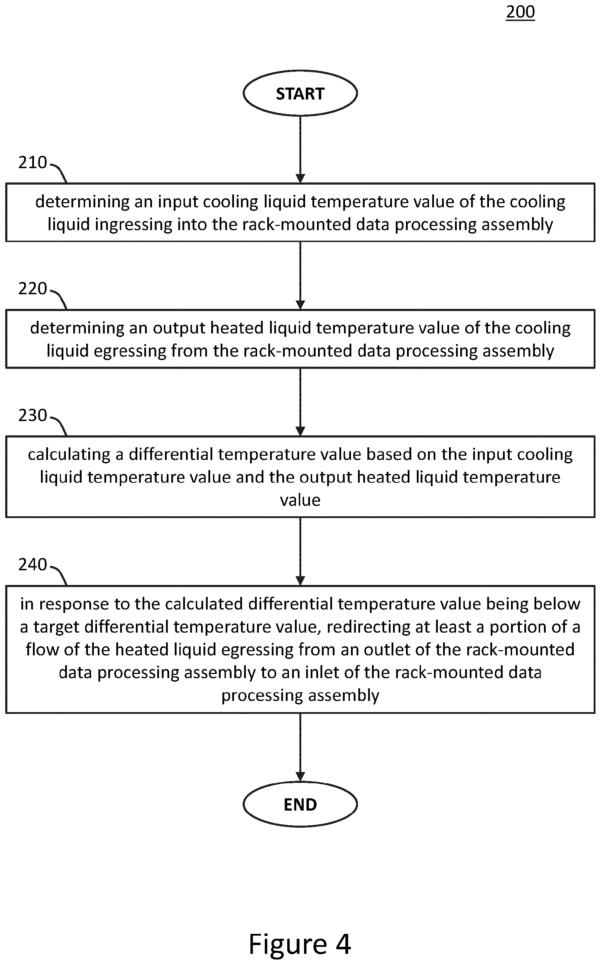

With this said, Figure 4 illustrates a flow diagram of a process 200 of controlling temperature of a cooling liquid 122 of rack-mounted assemblies 110A-110N, in accordance with implementations of the present technology. In some implementations, the process 200 or portions thereof may be executed by the controller 140. The controller 140 may be using a proportional-integral-derivative (PID) method amongst other methods.

The process 200 commences at task block 210, in which the input cooling liquid 122 temperature value of the cooling liquid 122 ingressing into the rack-mounted assemblies 110A-110N is determined. At task block 220, for each individual rack-mounted assembly 110A-110N, process 200 determines the output heated liquid temperature value of the cooling liquid egressing from the rack-mounted assemblies 110A-110N.

At task block 230, for each of the individual rack-mounted assemblies 110A-110N, process 200 calculates a differential temperature value based on the input cooling liquid temperature value and the output heated liquid temperature value. Then, at task block 240, in response to the calculated differential temperature value being below a target differential temperature value, process 200 redirects at least a portion of a flow of the heated liquid egressing from an outlet 128A-128N of the rack-mounted assembly 110A-110N to an inlet 124A-124N, 126A-126N of the rack-mounted assembly 110A-110N. Different implementations of said redirections are illustrated and described in greater detail hereinafter. After the redirection, process 200 terminates.

Referring back to Figure 1, as illustrated, the liquid cooling system 101 also includes an auxiliary cooling circuit 151A-151N. Although not shown, the auxiliary cooling circuit 151A-151N may also include an auxiliary pump to drive and maintain adequate flow rates of the redirected heated liquids. Accordingly, during process step 240 of process 200, as shown by Figure 4, when it is determined that the calculated differential temperature value of the respective rack-mounted assembly 110A-110N is below the target differential temperature value, the valve 138A-138N of the corresponding rack-mounted assembly 110A-110N redirects at least a portion of the flow of the heated liquid egressing from the outlet 128A-128N to the auxiliary cooling circuit 151A-151N. The auxiliary cooling circuit 151A-151N conveys the heated liquid to a second liquid cooling block 116B-116N of a second rack-mounted assembly 110B-110N downstream from the respective rack-mounted assembly via a second inlet 126B-126N. The redirected heated liquid absorbs additional heat generated by the heat-generating electronic data processing elements 112A-112N of the second rack-mounted assembly 110B-110N and the additionally heated liquid exits the second rack-mounted assembly 110B-110N.

As long as the target differential temperature value is not reached, the heated liquid will continue to be redirected to the second rack-mounted assembly 110B-110N downstream from the respective rack-mounted assembly and so on to a third, fourth, N-th, etc. rack-mounted assembly 110B-110N. In this manner, the target differential temperature value may be reached quicker and maintained easier to thereby improve the liquid cooling system 101 efficiency. In some implementations, the target differential temperature value may be set as a range, such as for example, set between approximately 10 degrees Celsius and approximately 30 degrees Celsius. In some other implementations, the target differential temperature value may be set as a discrete value, such as for example, 20 degrees Celsius or as deemed appropriate for the specific liquid cooling system design.

If, during the process step 240 of process 200, as shown by Figure 4, it is determined that the calculated differential temperature value of the respective rack-mounted assembly 110A-110N is above the target differential temperature value, then the heated liquid is conveyed back, via the cooling circuit 130, to the dry cooling module 120 for recooling without being redirected to the second rack-mounted assembly 110B-110N.

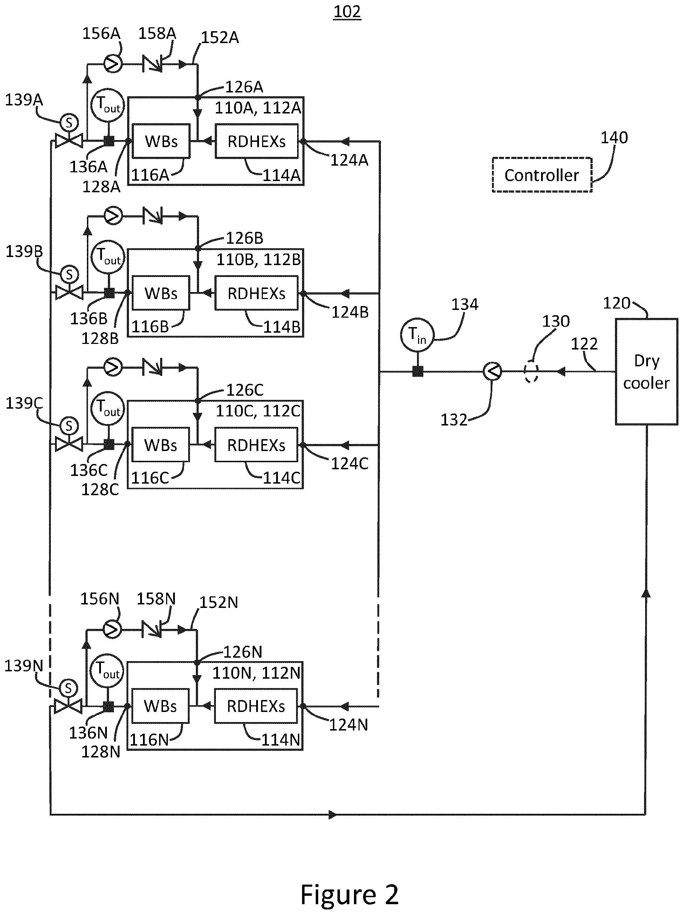

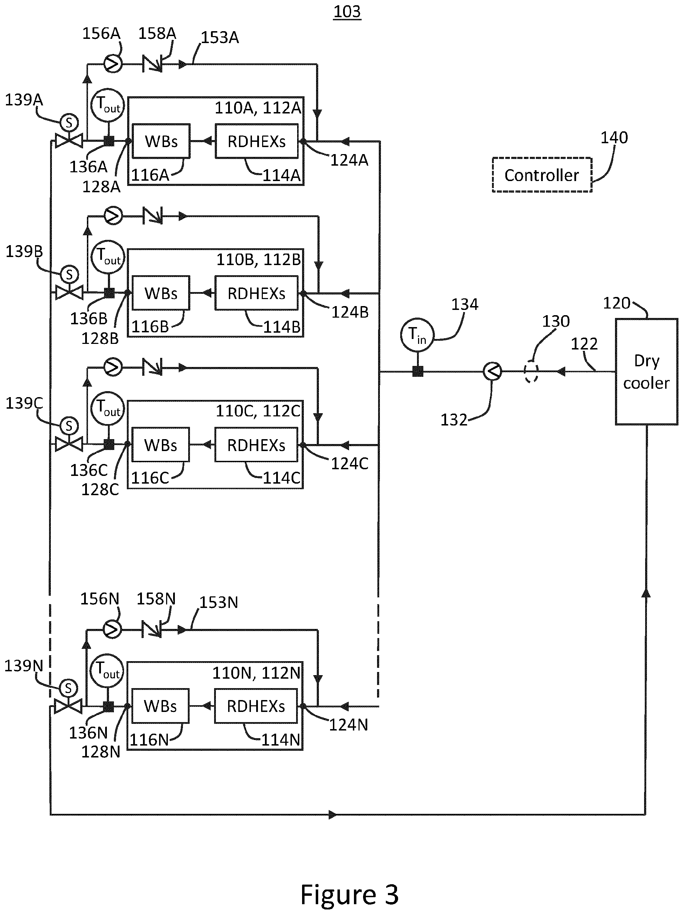

Figures 2 and 3 illustrate alternative implementations of the present technology with different types of valves and auxiliary cooling circuits used in liquid cooling arrangements for rack-mounted assemblies.

In particular, Figure 2 illustrates a general architecture of a liquid cooling system 102 for rack-mounted assemblies 110A-110N, in accordance with another implementation of the present technology. The liquid cooling system 102 of Figure 2 is similar to the liquid cooling system 101 of Figure 1, except that the valves 138A-138N are replaced by valves 139A-139N.

The valves 139A-139N, which in some examples of the nonlimiting implementations, may comprise pressure independent control valves (e.g., AB-QM valves) that are fluidly-coupled to the respective rack-mounted assemblies 110A-110N. Each valve 139A-139N is configured to regulate and direct the flow of the heated liquid egressing from the respective rack-mounted assembly 110A-110N.

In this implementation, the controller 140 is communicatively coupled to the input liquid temperature sensor 134, to each of the individual output liquid temperature sensors 136A-136N of the respective rack-mounted assemblies 110A-110N, and to each of the individual valves 139A-139N of the respective rack-mounted assemblies 110A-110N.

Based on the measured input cooling liquid 122 temperature value and the output heated liquid temperature value of each of the rack-mounted assemblies 110A-110N, the valves 139A-139N are controlled to regulate and direct the flow of the heated liquid egressing from each of the rack-mounted assemblies 110A-110N to balance and maintain an optimal differential temperature value between the supplied cooling liquid 122 and the returned heated liquid of the liquid cooling system 102. Maintaining this optimal differential temperature value results in improved liquid cooling system 102 efficiency.

As illustrated in Figure 2, the liquid cooling system 102 also includes an auxiliary cooling circuit 152A-152N. Each auxiliary cooling circuit 152A-152N incorporates an auxiliary pump 156A-156N to drive and maintain adequate flow rates of the redirected heated liquids. Each auxiliary cooling circuit 152A-152N may also incorporates a check valve 158A-158N to prevent the backflow of the heated liquid.

Referring simultaneously to Figures 2 and 4, when it is determined at process step 240 of process 200 that the calculated differential temperature value of the respective rack-mounted assembly 110A-110N is below the target differential temperature value, the valve 139A-139N of the corresponding rack-mounted assembly 110A-110N redirects at least a portion of the flow of the heated liquid egressing from the outlet 128A-128N to the auxiliary cooling circuit 152A-152N. The auxiliary cooling circuit 152A-152N conveys the heated liquid to the liquid cooling block 116A-116N of the same rack-mounted assembly 110A-110N via the second inlet 126A-126N. The redirected heated liquid absorbs additional heat generated by the heat-generating electronic data processing elements 112A-112N and the additionally heated liquid exits the rack-mounted assembly 110A-110N after re-circulation therethrough.

As long as the target differential temperature value is not reached, the heated liquid will continue to be redirected back again to the same rack-mounted assembly 110A-110N to absorb additional heat. In this manner, the target differential temperature value may be reached quicker and maintained easier to thereby improve the liquid cooling system 102 efficiency. In some implementations, the target differential temperature value may be set as a range, such as for example, set between approximately 10 degrees Celsius and approximately 30 degrees Celsius. In some other implementations, the target differential temperature value may be set as a discrete value, such as for example, 20 degrees Celsius or as deemed appropriate for the specific liquid cooling system design.

If, during the process step 240 of process 200, as shown by Figure 4, it is determined that the calculated differential temperature value of the respective rack-mounted assembly 110A-110N is above the target differential temperature value, then the heated liquid is conveyed back, via the cooling circuit 130 to the dry cooling module 120 for recooling.

Figure 3 illustrates a general architecture of a liquid cooling system 103 for rack-mounted assemblies 110A-110N, in accordance with yet another implementation of the present technology. The liquid cooling system 103 of Figure 3 is similar to the liquid cooling system 102 of Figure 2, except that the auxiliary cooling circuits 152A-152N are replaced by auxiliary cooling circuit 153A-153N.

Based on the measured input cooling liquid 122 temperature value and the output heated liquid temperature value of each of the rack-mounted assemblies 110A-110N, the valves 139A-139N are controlled to regulate and direct the flow of the heated liquid egressing from each of the rack-mounted assemblies 110A-110N to balance and maintain an optimal differential temperature value between the supplied cooling liquid 122 and the returned heated liquid of the liquid cooling system 103. Maintaining this optimal differential temperature value results in improved liquid cooling system 103 efficiency.

As illustrated in Figure 3, the liquid cooling system 103 also includes an auxiliary cooling circuit 153A-153N. Each auxiliary cooling circuit 153A-153N incorporates an auxiliary pump 156A-156N to drive and maintain adequate flow rates of the redirected heated liquids. Each auxiliary cooling circuit 153A-153N may also incorporates a check valve 158A-158N to prevent the backflow of the heated liquid.

Referring simultaneously to Figures 3 and 4, when it is determined at process step 240 of process 200 that the calculated differential temperature value of the respective rack-mounted assembly 110A-110N is below the target differential temperature value, the valve 139A-139N of the corresponding rack-mounted assembly 110A-110N redirects at least a portion of the flow of the heated liquid egressing from the outlet 128A-128N to the auxiliary cooling circuit 153A-153N. The auxiliary cooling circuit 153A-153N conveys the heated liquid to the heat exchanger 114A-114N of the same rack-mounted assembly 110A-110N via the inlet 124A-124N. The redirected heated liquid absorbs additional heat generated by the heat-generating electronic data processing elements 112A-112N and the additionally heated liquid exits the rack-mounted assembly 110A-110N after re-circulation therethrough.

As long as the target differential temperature value is not reached, the heated liquid will continue to be redirected back again to the same rack-mounted assembly 1 10A-1 10N to absorb additional heat. In this manner, the target differential temperature value may be reached quicker and maintained easier to thereby improve the liquid cooling system 103 efficiency. In some implementations, the target differential temperature value may be set as a range, such as for example, set between approximately 10 degrees Celsius and approximately 30 degrees Celsius. In some other implementations, the target differential temperature value may be set as a discrete value, such as for example, 20 degrees Celsius or as deemed appropriate for the specific liquid cooling system design.

If, during the process step 240 of process 200, as shown by Figure 4, it is determined that the calculated differential temperature value of the respective rack-mounted assembly 110A-110N is above the target differential temperature value, then the heated liquid is conveyed back, via the cooling circuit 130 to the dry cooling module 120 for recooling.

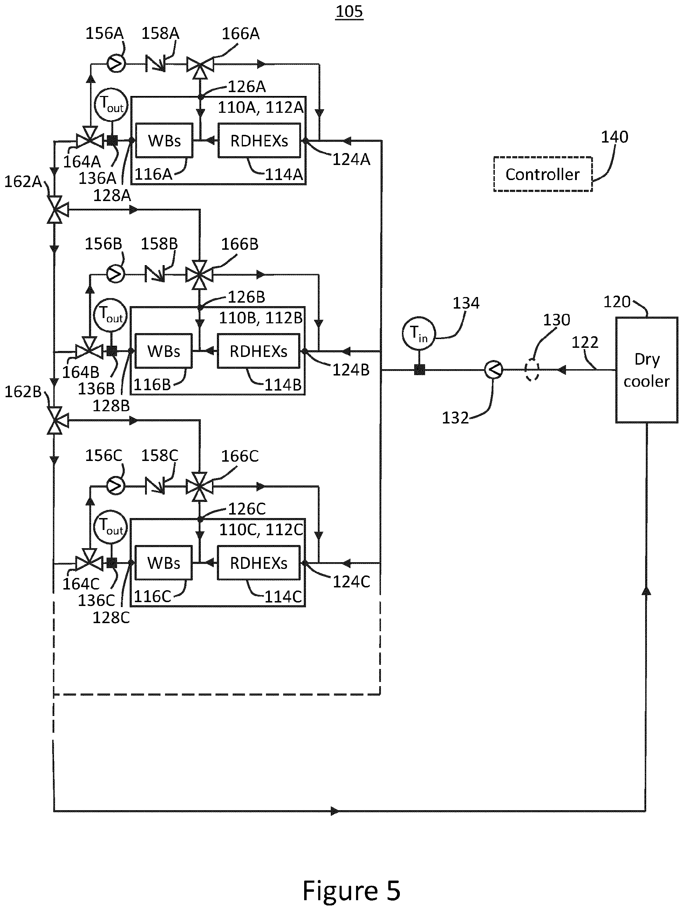

It will be appreciated, that the above-described implementations of the present technology may be modified. For example, in some implementations, the liquid cooling systems 101, 102, 103 may be at least partially or fully combined. For example, in some implementations, an auxiliary cooling circuit may also incorporates a 3-way solenoid valve (not shown) to redirect at least a portion of the flow of the heated liquid to either or to both of the liquid cooling block 116A-116N and the heat exchanger 114A-114N of the same rack-mounted assembly 110A-110N. Yet, in some other modified implementations, as shown in Figure 5, a liquid cooling system 105 includes multiple auxiliary cooling circuits and portion of the flow of the heated liquid may be redirected in multiple fluid paths by controlling valves 162A-162N, 164A-164N, and 166A-166N. Because the liquid cooling system 105 contains similar components with like reference numerals as the liquid cooling system 101, for the sake of brevity, detailed descriptions of such components will not be repeated unless necessary for the understanding of the implementation.

Other modifications are also possible. For example, flow sensors may also be added. Furthermore, in some implementations, additionally or alternatively the cooling circuit 130 may also includes a global output liquid temperature sensor (not shown). The global output liquid temperature sensor is configured to measure the global output heated liquid temperature values received by the dry cooling unit 120. The controller 140 may also be communicatively coupled to the global output liquid temperature sensor. Therefore, the liquid cooling systems 101, 102, 103 may adjust the valves 138A-138N, 139A-139N to regulate and direct the flow of the heated liquid egressing from each of the rack-mounted assemblies 110A-110N at least in part based on the measured input cooling liquid 122 temperature value and the global output heated liquid temperature value.

Yet, other modifications and improvements are also possible. For example, in some implementations, the controller 140 may also adjust the valves 138A-138N, 139A-139N based at least in part on a predicted power consumption of the rack-mounted assemblies 110A-110N.

Moreover, in other implementations, a machine learning model may be executed by the controller 140 to determine a forthcoming power consumption of the rack-mounted assemblies 110A-110N. In an exemplary implementation, the machine learning model is based at least in part on a history of power consumption of the rack-mounted assemblies 110A-110N. The machine learning model may have been trained by a machine learning algorithm (MLA). A liquid cooling control model may be executed, based at least in part on the estimated forthcoming power consumption from the machine learning model, to determine at least one control signal for controlling the liquid cooling system. The controller 140 may thus adjust the valves 138A-138N, 139A-139N at least in part to control the liquid cooling system based on the at least one control signal.

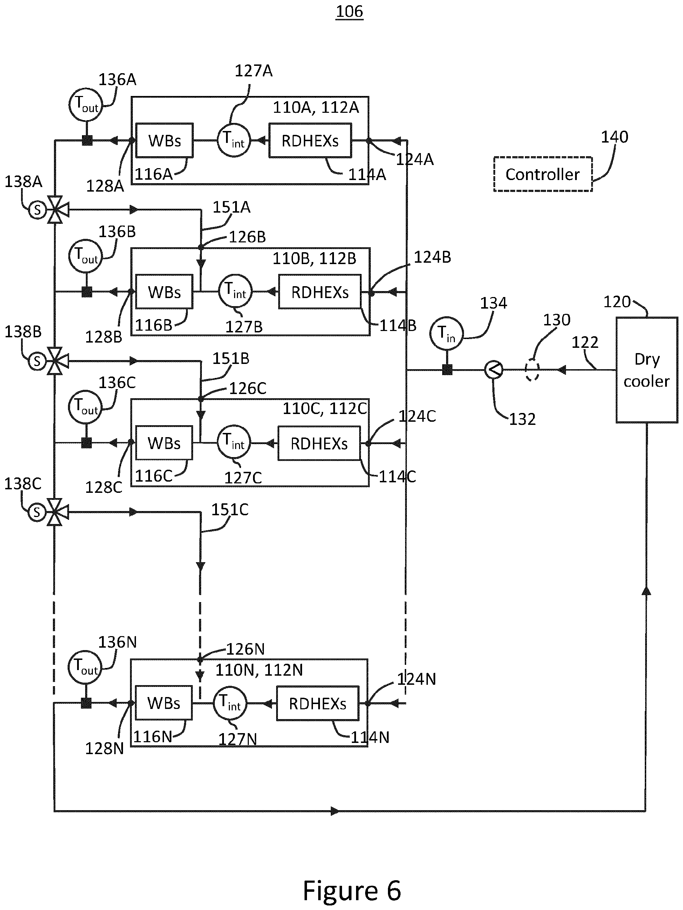

Figure 6 is a high-level functional block diagram of a liquid cooling arrangement 106 for rack-mounted assemblies, in accordance with some implementations of the present technology. Because the liquid cooling system 106 contains similar components with like reference numerals as the liquid cooling system 101, for the sake of brevity, detailed descriptions of such components will not be repeated unless necessary for the understanding of the implementation.

In this implementation, the liquid cooling arrangement 106 includes temperature sensors 127A-127N communicably connected to the controller 140 and configured to determine a temperature of the cooling liquid at an outlet of the heat exchangers 114A-114N respectively, and before entering the liquid cooling blocks 116A-116N respectively. Therefore, based on the data provided by the temperature sensors 134, the temperature sensor 127A-127N, and the temperature sensor 136A-136N, the controller 140 may determine the following temperature differences, for each rack-mounted assembly 110ᵢ:
ΔT_{WC,i}=T_{out,i}-T_{int,i} where T_{out,i} is the temperature measured by the temperature sensor 136i, and T_{int,i} is the temperature measured by the temperature sensor 127i,
ΔT_{AC,i}=T_{int,i}-Tᵢₙ where T_{int,i} is the temperature measured by the temperature sensor 127i and Tᵢₙ is the temperature measured by the temperature sensor 134, and
ΔT_{TOT,i}= ΔT_{WC,i}+ ΔT_{AC,i}.

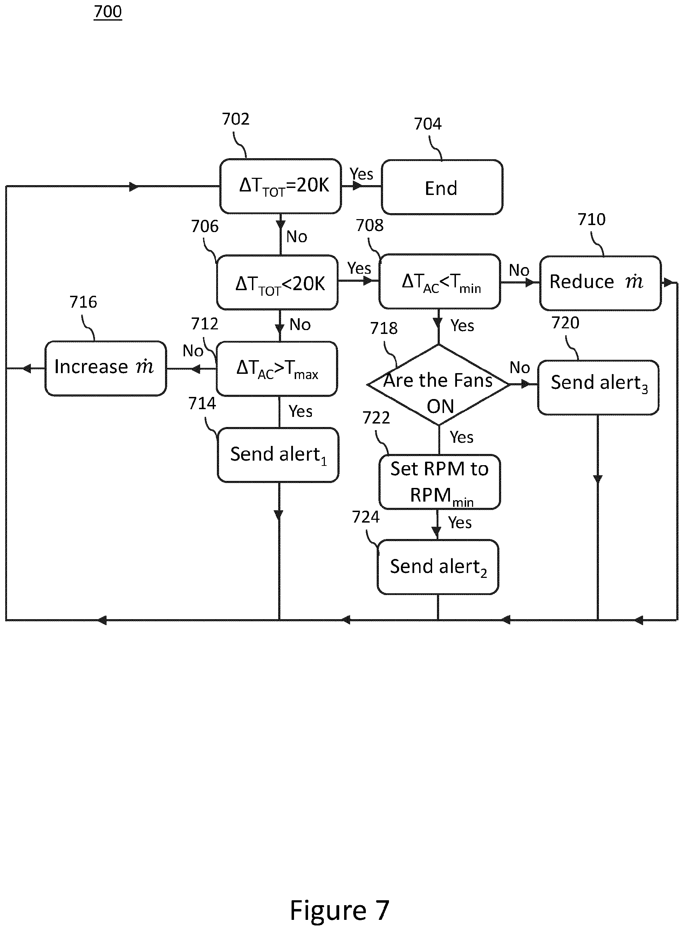

In use the controller 140 of the liquid cooling arrangement 106 may execute a control pipeline 700 shown on Figure 7 to operate under degraded mode and correct failures that may occur during normal operation of the liquid cooling arrangement 106. The pipeline 700 is executed for each rack-mounted assembly 110 and starts with determining, at operation 702, whether ΔT_{TOT,i} is equal to a pre-determined value (20K in this non-limiting example). If not, the controller 140 determines, at operation 706 whether ΔT_{TOT,i} is below the pre-determined value, and end the pipeline 700 at operation 704 otherwise.

In response to ΔT_{TOT,i} being below the pre-determined value at operation 706, the controller 140 determines whether the ΔT_{AC,i} is below a first temperature threshold Tₘᵢₙ at operation 708, and determines whether the ΔT_{AC,i} is above a second temperature threshold Tₘₐₓ at operation 712.

In response to ΔT_{AC,i} being below the pre-determined value at operation 708, the controller 140 determines whether the fans of the heat exchanger 114; are actually operating under normal conditions (e.g. with a rotating speed above a given threshold) at operation 718, and causes a decrease of the flow rate of the cooling liquid in the rack-mounted assembly 110; at operation 712 (e.g. by adjusting a rotation speed of the pump 132 and/or operating a valve at the inlet 124ᵢ of the rack-mounted assembly 110ᵢ).

In response to the fans of the heat exchanger 114ᵢ actually operating under normal conditions, the controller 140 reduces a rotation speed of the fans to a pre-determined value RPMₘᵢₙ and emits an alert message ("alert₂") to an operator of the liquid cooling arrangement 106 indicative of a relatively low amount of thermal energy to be collected by the liquid cooling arrangement 106. The controller 140 emits an alert message ("alerts") to an operator of the liquid cooling arrangement 106 indicative of a failure of the fans of the heat exchanger 114ᵢ in response to the fans not under normal conditions.

In response ΔT_{AC,i} being above the second temperature threshold Tₘₐₓ at operation 712, the controller 140 emits an alert message ("alert₁") to an operator of the liquid cooling arrangement 106 indicative of a potential clogging of the piping of the liquid cooling arrangement 106 in the rack-mounted assembly 110ᵢ. Said clogging may cause algae within the piping, which can reduce the cooling performances of the liquid cooling arrangement 106. The controller 140 causes the flow rate of the cooling liquid to increase in the rack-mounted assembly 110ᵢ at operation 712 (e.g. by adjusting a rotation speed of the pump 132 and/or operating a valve at the inlet 124ᵢ of the rack-mounted assembly 110ᵢ).

It should be noted that at least some of the operations of the pipeline 700 may be included in the method 200.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

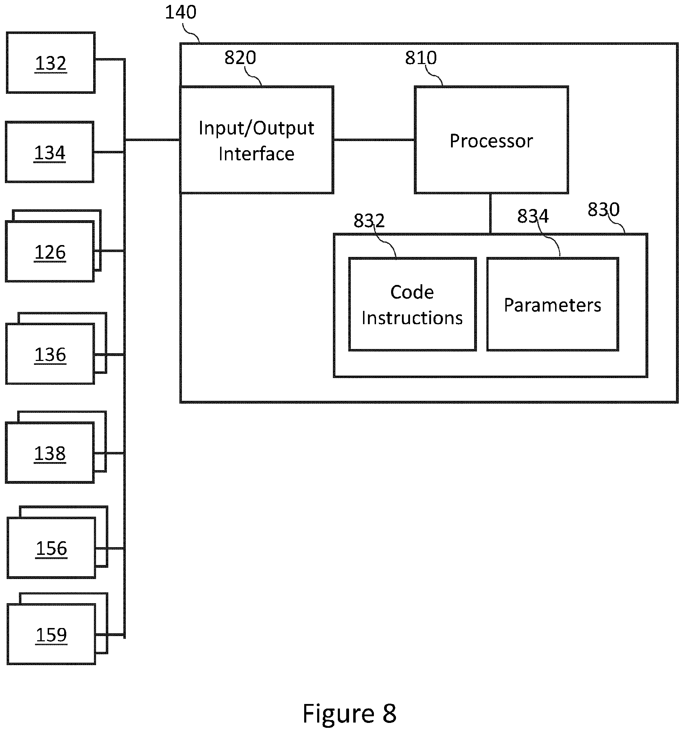

As an example, Figure 8 is a schematic block diagram of the controller 140 of the liquid cooling arrangements 101, 102, 103, 105, 106 according to an embodiment of the present technology. The controller 140 comprises a processor or a plurality of cooperating processors (represented as a processor 810 for simplicity), a memory device or a plurality of memory devices (represented as a memory device 830 for simplicity), and a input/output interface 820 allowing the controller 140 to communicate with other components of the liquid cooling arrangements 101, 102, 103, 105, 106 and/or other components in remote communication with the liquid cooling arrangements 101, 102, 103, 105, 106. The processor 810 is operatively connected to the memory device 830 and to the input/output interface 820. The memory device 830 includes a storage for storing parameters 834, including for example and without limitation the above-mentioned temperature thresholds. The memory device 830 may comprise a non-transitory computer-readable medium for storing code instructions 832 that are executable by the processor 810 to allow the controller 140 to perform the various tasks allocated to the controller 140 in the method 200 and/or the pipeline 700.

The controller 140 is operatively connected, via the input/output interface 820, to the pump 132, the input liquid temperature sensor 134, the temperature sensors 127A-127N, the output liquid temperature sensors 136A-136N, the valves 138A-138N, the auxiliary pumps 156A-156N, the valves 139A-139N. The controller 700 executes the code instructions 732 stored in the memory device 730 to implement the various above-described functions that may be present in a particular embodiment. Figure 7 as illustrated represents a non-limiting embodiment in which the controller 700 orchestrates operations of the liquid cooling arrangements 101, 102, 103, 105, 106. This particular embodiment is not meant to limit the present disclosure and is provided for illustration purposes.

It should be expressly understood that not all technical effects mentioned herein need to be enjoyed in each and every implementation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A computer-implemented method for controlling temperature of a cooling liquid (122) of a rack-mounted assembly (110A-110N), comprising:
determining an input cooling liquid temperature value of the cooling liquid ingressing into the rack-mounted assembly;
determining an output heated liquid temperature value of the cooling liquid egressing from the rack-mounted assembly;
calculating a differential temperature value based on the input cooling liquid temperature value and the output heated liquid temperature value; and
in response to the calculated differential temperature value being below a target differential temperature value, redirecting at least a portion of a flow of the heated liquid egressing from an outlet (128A-128N) of the rack-mounted assembly to an inlet (124A-124N, 126A-126N) of the rack-mounted assembly.

2. The method of claim 1, wherein, the redirection is performed by adjusting a valve (138A-138N, 139A-139N).

3. The method of claims 1 or 2, wherein, the redirection causes the at least a portion of the flow of the heated liquid being directed to the inlet of a second rack-mounted assembly (110B) downstream from the first rack-mounted assembly (110A).

4. The method of claims 1 or 2, wherein, the redirection causes the at least a portion of the flow of the heated liquid being directed to the inlet of the same rack-mounted assembly.

5. The method of claims 1 or 2, further comprising:
predicting, using a machine learning model, a power consumption of the rack-mounted assembly, and
adjusting the valve based at least in part on the predicted power consumption of the rack-mounted assembly.

6. The method of any one of claims 1 to 5, wherein at least one rack-mounted assembly comprises:
an air-to-liquid heat exchanger (114) configured to receive the cooling liquid ingressing into the at least one rack-mounted assembly; and
a liquid cooling block (116) receiving the cooling liquid from the air-to-liquid heat exchanger (114), arranged to be in respective thermal contact with a heat-generating electronic data processing element and configured to output the cooling liquid egressing from the rack-mounted assembly,
the method further comprising:
determining an intermediary heated liquid temperature value of the cooling liquid egressing from the air-to-liquid heat exchanger (114) and ingressing into liquid cooling block (116);
determining a second differential temperature value based on the input cooling liquid temperature value and the intermediary heated liquid temperature value; and
causing, in response to the first and second differential temperature values being below a first temperature threshold and a second temperature threshold (Tₘᵢₙ) respectively, a decrease of a flow rate of the cooling liquid in the rack-mounted assembly.

7. The method of claim 6, further comprising:
causing, in response to the first differential temperature values being above the first temperature threshold and the second differential temperature values being below a third temperature threshold (Tₘₐₓ), an increase of the flow rate of the cooling liquid in the rack-mounted assembly.

8. The method of claim 6 or 7, further comprising:
reducing, in response to the first differential temperature values being below the first temperature threshold and the second differential temperature values being above the second temperature threshold (Tₘᵢₙ), a rotation speed of at least one fan of the air-to-liquid heat exchanger (114).

9. A non-transitory computer-readable medium comprising computer-readable instructions that, upon being executed by a system, cause the system to perform method of any one of claims 1 to 8.

10. A liquid cooling system (101-103) for a rack-mounted assembly (110A-110N), comprising:
a cooling circuit (130) configured to circulate a cooling liquid (122) to the rack-mounted assembly and to circulate a heated liquid from the rack-mounted assembly;
a dry cooling module (120) configured to supply the cooling liquid to the rack-mounted assembly and to receive the heated liquid from the rack-mounted assembly for recooling and recirculation by the cooling circuit;
the cooling circuit comprising:
a pump (132) to drive a flow of the cooling liquid supplied by the dry cooling module and to drive a flow of the heated liquid received by the dry cooling module,
an input liquid temperature sensor (134) to measure an input cooling liquid temperature value ingressing into the rack-mounted assembly, an output liquid temperature sensor (136A-136N) to measure an output heated liquid temperature value egressing from the rack-mounted assembly, and
a valve (138A-138N, 139A-139N) to regulate and direct the flow of the heated liquid egressing from the rack-mounted assembly;
a controller (140) communicatively coupled to the input liquid temperature sensor, the output liquid temperature sensor, and the valve, the controller configured to execute a process comprising:
reading the input cooling liquid temperature value provided by the input liquid temperature sensor,
reading the output heated liquid temperature value provided by the output liquid temperature sensor,
calculating a differential temperature value based on the input cooling liquid temperature value and the output heated liquid temperature value, and
in response to the calculated differential temperature value being below a target differential temperature value, redirecting at least a portion of the flow of the heated liquid egressing from an outlet (128A-128N) of the rack-mounted assembly to an inlet (124A-124N, 126A-126N) of the rack-mounted assembly.

11. The liquid cooling system of claim 10, further comprising:
a heat exchanger (114A-114N) arranged to be in respective thermal contact with a heat-generating electronic data processing element (112A-112N) of the rack-mounted assembly, the heat exchanger being fluidly-coupled to the cooling circuit to receive the cooling liquid and circulate therethrough, and
a liquid cooling block (116A-116N) arranged to be in respective thermal contact with the heat-generating electronic data processing element, the liquid cooling block being fluidly-coupled to the cooling circuit to receive the cooling liquid and circulate therethrough.

12. The liquid cooling system of claim 10, wherein, the redirection causes the at least a portion of the flow of the heated liquid being directed to a second liquid cooling block (116B) of a second rack-mounted assembly (110B) downstream from the first rack-mounted assembly (110A).

13. The liquid cooling system of claim 10, wherein, the redirection causes the at least a portion of the flow of the heated liquid being directed to the liquid cooling block of the same rack-mounted assembly.

14. The liquid cooling system of claim 10, wherein, the redirection causes the at least a portion of the flow of the heated liquid being directed to the heat exchanger of the same rack-mounted assembly.

15. The liquid cooling system of any one of claims 10 to 14, wherein, the controller further executes:
predicting, using a machine learning model, a power consumption of the rack-mounted assembly, and
adjusting the valve based at least in part on the predicted power consumption of the rack-mounted assembly.

## Amended claims

### Amended claims in accordance with Rule 137(2) EPC.

**1.** A computer-implemented method for controlling temperature of a cooling liquid (122) of a liquid cooling system 101 comprising at least one rack-mounted assembly (110A-110N), comprising:
determining an input cooling liquid temperature value of the cooling liquid ingressing into the rack-mounted assembly by an input liquid temperature sensor (134);
determining an output heated liquid temperature value of the cooling liquid egressing from the rack-mounted assembly by an output liquid temperature sensor (136A, 136B, 136C);
calculating a differential temperature value based on the input cooling liquid temperature value and the output heated liquid temperature value; and
in response to the calculated differential temperature value being below a target differential temperature value, redirecting at least a portion of a flow of the heated liquid egressing from an outlet (128A-128N) of the rack-mounted assembly to an inlet (124A-124N, 126A-126N) of the rack-mounted assembly by adjusting a valve (138A, 138B, 138C, 139A, 139B, 139C).

**2.** The method of claim 1, wherein, the redirection causes the at least a portion of the flow of the heated liquid being directed to the inlet of a second rack-mounted assembly (110B) downstream from the first rack-mounted assembly (110A).

**3.** The method of claims 1 or 2, wherein, the redirection causes the at least a portion of the flow of the heated liquid being directed to the inlet of the same rack-mounted assembly.

**4.** The method of claims 1 or 2, further comprising:
predicting, using a machine learning model, a power consumption of the rack-mounted assembly, and
adjusting the valve based at least in part on the predicted power consumption of the rack-mounted assembly.

**5.** The method of any one of claims 1 to 4, wherein at least one rack-mounted assembly comprises:
an air-to-liquid heat exchanger (114) configured to receive the cooling liquid ingressing into the at least one rack-mounted assembly; and
a liquid cooling block (116) receiving the cooling liquid from the air-to-liquid heat exchanger (114), arranged to be in respective thermal contact with a heat-generating electronic data processing element and configured to output the cooling liquid egressing from the rack-mounted assembly,
the method further comprising:
determining an intermediary heated liquid temperature value of the cooling liquid egressing from the air-to-liquid heat exchanger (114) and ingressing into liquid cooling block (116);
determining a second differential temperature value based on the input cooling liquid temperature value and the intermediary heated liquid temperature value; and
causing, in response to the first and second differential temperature values being below a first temperature threshold and a second temperature threshold (Tₘᵢₙ) respectively, a decrease of a flow rate of the cooling liquid in the rack-mounted assembly.

**6.** The method of claim 5, further comprising:
causing, in response to the first differential temperature value being above the first temperature threshold and the second differential temperature value being below a third temperature threshold (Tₘₐₓ), an increase of the flow rate of the cooling liquid in the rack-mounted assembly.

**7.** The method of claim 5 or 6, further comprising:
reducing, in response to the first differential temperature value being below the first temperature threshold and the second differential temperature value being above the second temperature threshold (Tₘᵢₙ), a rotation speed of at least one fan of the air-to-liquid heat exchanger (114).

**9.** A liquid cooling system (101-103), comprising:
at least one rack-mounted assembly (110A-110N);
a cooling circuit (130) configured to circulate a cooling liquid (122) to the rack-mounted assembly and to circulate a heated liquid from the rack-mounted assembly;
a dry cooling module (120) configured to supply the cooling liquid to the rack-mounted assembly and to receive the heated liquid from the rack-mounted assembly for recooling and recirculation by the cooling circuit;
the cooling circuit comprising:
a pump (132) to drive a flow of the cooling liquid supplied by the dry cooling module and to drive a flow of the heated liquid received by the dry cooling module,
an input liquid temperature sensor (134) to measure an input cooling liquid temperature value ingressing into the rack-mounted assembly, an output liquid temperature sensor (136A-136N) to measure an output heated liquid temperature value egressing from the rack-mounted assembly, and
a valve (138A-138N, 139A-139N) to regulate and direct the flow of the heated liquid egressing from the rack-mounted assembly;
a controller (140) communicatively coupled to the input liquid temperature sensor, the output liquid temperature sensor, and the valve, the controller configured to execute a process comprising:
reading the input cooling liquid temperature value provided by the input liquid temperature sensor,
reading the output heated liquid temperature value provided by the output liquid temperature sensor,
calculating a differential temperature value based on the input cooling liquid temperature value and the output heated liquid temperature value, and
in response to the calculated differential temperature value being below a target differential temperature value, redirecting at least a portion of the flow of the heated liquid egressing from an outlet (128A-128N) of the rack-mounted assembly to an inlet (124A-124N, 126A-126N) of the rack-mounted assembly by the valve (138A-138N, 139A-139N).

**10.** The liquid cooling system of claim 10, further comprising:
a heat exchanger (114A-114N) arranged to be in respective thermal contact with a heat-generating electronic data processing element (112A-112N) of the rack-mounted assembly, the heat exchanger being fluidly-coupled to the cooling circuit to receive the cooling liquid and circulate therethrough, and
a liquid cooling block (116A-116N) arranged to be in respective thermal contact with the heat-generating electronic data processing element, the liquid cooling block being fluidly-coupled to the cooling circuit to receive the cooling liquid and circulate therethrough.

**11.** The liquid cooling system of the preceding claim, wherein, the redirection causes the at least a portion of the flow of the heated liquid being directed to a second liquid cooling block (116B) of a second rack-mounted assembly (110B) downstream from the first rack-mounted assembly (110A).

**12.** The liquid cooling system of claim 8, wherein, the redirection causes the at least a portion of the flow of the heated liquid being directed to the liquid cooling block of the same rack-mounted assembly.

**13.** The liquid cooling system of claim 8, wherein, the redirection causes the at least a portion of the flow of the heated liquid being directed to the heat exchanger of the same rack-mounted assembly.

**14.** The liquid cooling system of any one of claims 8 to 13, wherein, the controller further executes:
predicting, using a machine learning model, a power consumption of the rack-mounted assembly, and
adjusting the valve based at least in part on the predicted power consumption of the rack-mounted assembly.
